(19) Europäisches Patentamt
European Patent Office
Office européen des brevets

(11) **EP 2 307 588 B1**

(12) **EUROPÄISCHE PATENTSCHRIFT**

(45) Veröffentlichungstag und Bekanntmachung des Hinweises auf die Patenterteilung:
**22.04.2015  Patentblatt 2015/17**

(21) Anmeldenummer: **09777408.7**

(22) Anmeldetag: **23.07.2009**

(51) Int Cl.:
*C23C 14/06* (2006.01)          *C23C 14/02* (2006.01)
*B05D 5/06* (2006.01)          *C23C 14/04* (2006.01)

(86) Internationale Anmeldenummer:
**PCT/EP2009/005368**

(87) Internationale Veröffentlichungsnummer:
**WO 2010/009889 (28.01.2010 Gazette 2010/04)**

(54) **VERFAHREN ZUR HERSTELLUNG EINES SCHICHTSYSTEMS AUF EINEM SUBSTRAT, SOWIE SCHICHTSYSTEM**

METHOD FOR PRODUCING A LAYER SYSTEM ON A SUBSTRATE AND LAYER SYSTEM

PROCÉDÉ DE FABRICATION D'UN SYSTÈME DE COUCHES SUR UN SUBSTRAT ET SYSTÈME DE COUCHES

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **25.07.2008   DE 102008034991**

(43) Veröffentlichungstag der Anmeldung:
**13.04.2011   Patentblatt 2011/15**

(73) Patentinhaber: **Bühler Alzenau GmbH
63755 Alzenau (DE)**

(72) Erfinder:
• **PISTNER, Jürgen
63755 Alzenau-Michelbach (DE)**

• **SCHMAUDER, Torsten
D-63329 Egelsbach (DE)**
• **KÜPER, Stephan
61352 Bad Homburg v. d. H. (DE)**

(74) Vertreter: **Pohlmann, Bernd Michael
Reinhardt & Pohlmann
Patentanwälte
Rossmarkt 12
60311 Frankfurt am Main (DE)**

(56) Entgegenhaltungen:
**JP-A- 5 065 650     US-A1- 2003 031 891**

**Beschreibung**

Die vorliegende Erfindung betrifft ein Verfahren zur Herstellung eines Schichtsystems auf einem Substrat, sowie ein Schichtsystem auf einem Substrat, jeweils entsprechend den Oberbegriffen der unabhängigen Patentansprüche. Ferner betrifft die Erfindung ein Gehäuse für ein elektrisches Gerät mit einem Schichtsystem.

Die Metallisierung von dielektrischen Substraten, beispielsweise mittels Vakuum-Metallisierung, ist bereits seit einiger Zeit bekannt. Als Vakuum-Metallisierungsverfahren kann beispielsweise das thermische Verdampfen oder die Kathodenzerstäubung (Sputtern) verwendet werden.

Spätestens seit der US-Patentschrift US 4,431,711 ist ferner bekannt, dass Metalle, wie zum Beispiel Indium (In) oder Zinn (Sn) bei der Vakuum-Metallisierung zunächst im Inselwachstum aufwachsen können. Dünne Schichten dieser Metalle bestehen dabei aus Inseln, die nicht in elektrischem Kontakt zueinander stehen. Diese Schichten weisen bereits optische Eigenschaften des Metalls auf - etwa metallischen Glanz - sind jedoch nicht leitfähig und können damit unanfällig gegen elektrochemische Korrosionsmechanismen sein.

Als elektrisch nicht-leitfähige, vakuum-metallisierte Schichten (Non-Conductive Vacuum Metallized, NCVM-Schichten) werden im Folgenden Schichten verstanden, die aus Metallen oder Metall-Legierungen bestehen, die durch ein Vakuum-Beschichtungsverfahren hergestellt sind und vorzugsweise im Frequenzbereich zwischen ca. 400 MHz und ca. 5 GHz keine merkliche Reflektion aufweisen.

Seit einigen Jahren hat sich ein neues Anwendungsgebiet für NCVM-Schichten eröffnet: Gehäuse für beispielsweise mobile Geräte mit drahtlosen Kommunikationsfunktionen, beispielsweise Mobiltelefone, elektronische Organizer, GPS-Navigationsgeräte, Radar-Abstandssensoren. Diese Gehäuse sollen einerseits eine metallisch anmutende Optik aufweisen und andererseits eine nahezu störungsfreie Umgebung für die im Inneren angebrachten Antennen darstellen. Elektrisch leitfähige metallische Schichten würden im üblicherweise verwendeten Frequenzbereich von ca. 400 MHz bis ca. 5 GHz die Funkwellen wenigstens teilweise reflektieren und so zu unerwünschten Sende- bzw. Empfangsverlusten führen. Deshalb werden derartige Gehäuse nicht mit leitfähigen metallischen Schichten, sondern mit NCVM-Schichten versehen.

Da die Hochfrequenz-Eigenschaften der NCVM-Schichten nur mit aufwendigen Messverfahren zu prüfen sind, wird oft der, mit einfachen Messgeräten (etwa Hand-Multimetern) gerade noch messbare Flächen-Gleichstromwiderstand als Kriterium angesehen, beispielsweise ein Wert von 20 MOhm/□ oder 1 GOhm/□. Der Flächenwiderstand $\rho_\square$ einer Schicht der Dicke d ist bei isotropem spezifischem Widerstand $\rho$ gemäß

$$\rho_\square = \rho/d$$

definiert. Der Flächenwiderstand einer Schicht kann mittels der Vier-Punkt-Methode oder der Van-der-Pauw-Methode gemessen werden. Im Folgenden wird der Flächenwiderstand in vereinfachter Schreibweise in Einheiten Ohm angegeben.

Farbige Schichtsysteme für metallische Reflektoren können auf verschiedene Weise realisiert werden:

- Reflektor mit einer teilabsorbierenden hochbrechenden Schicht, die etwa Nitride, Carbonitride, Oxide und unterstöchiometrische Varianten davon beinhaltet

- Reflektor mit einer dielektrische Schicht sowie halbdurchlässige Reflektions-Schichten.

Derartige Schichtsysteme sind üblicherweise elektrisch leitfähig.

Ferner sind farbige Interferenz-Schichtsysteme, bestehend aus einer Abfolge von hoch- und niederbrechenden dielektrischen Schichten bekannt. Nachteil dieser Schichtsysteme ist, dass der resultierende Farbeindruck sehr empfindlich von Schichtdickenschwankungen abhängig ist.

Aus dem Dokument JP 05 065 650 A ist die Herstellung einer dielektrischen Schicht mit eingebetteten Metallpartikeln bekannt, die jedoch den Nachteil einer komplizierten Prozessgestaltung aufweist.

Metallisch aussehende, auch eingefärbte, Beschichtungen können auch durch Lackiersysteme aufgebracht werden. Dies hat einige Nachteile. So wird beispielsweise oft über hohe Ausbeuteverluste von bis zu 60% in Folge von Lackierfehlern geklagt. Ferner sind meist mehrere Lackierschritte (Farblack, klarer Hartlack) nötig, was zusätzliche Kosten verursacht.

Die US 2003/0031891 A1 betrifft ein Verfahren zur Herstellung eines Schichtsystems auf einem dielektrischen Substrat und ein Schichtsystem. Das Schichtsystem weist eine auf dem Substrat aufgebrachte metallische Schicht, eine auf dieser aufgebrachte Isolatorschicht und eine weitere metallische Schicht. Das Verfahren umfasst drei aufeinander folgende Vakuumbeschichtungsschritte.

Aufgabe der Erfindung ist es, elektrisch nicht-leitfähige Schichtsysteme mit metallischem Aussehen und Transparenz im Radiofrequenzbereich zur Verfügung zu stellen.

Die Aufgabe wird gelöst mit den Merkmalen der unabhängigen Ansprüche. Vorteilhafte Ausführungsformen der Erfindung sind den abhängigen Ansprüchen zu entnehmen.

Bei dem erfindungsgemäßen Verfahren nach Anspruch 1 zur Herstellung eines Schichtsystems auf einem dielektrischen Substrat wird mit einem Beschichtungsschritt eine metallische Schicht auf das Substrat aufgebracht und darauf folgend mit einem weiteren Beschichtungsschritt eine weitere Schicht mit vorgegebener Schichtdicke aufgebracht, wobei die metallische Schicht einen Flächenwiderstand > 10 MOhm sowie einen mittleren Reflektionsgrad > 50% aufweist. Es ist vorgesehen, dass die weitere Schicht, wenn sie bei gleicher Schichtdicke mit dem weiteren Beschichtungsschritt auf das Substrat aufgebracht würde, einen Flächenwiderstand < 1 MOhm aufweisen würde, und dass das Schichtsystem aus der metallischen Schicht und der weiteren Schicht einen Flächenwiderstand > 10 MOhm aufweist.

Als dielektrisches Substrat wird im vorliegenden Text ein Substrat aus einem dielektrischen Material bezeichnet, wobei das Substrat auch eine dielektrische Teilschicht umfassen kann, auf die die metallische Schicht mit dem Beschichtungsschritt aufgebracht wird. Als metallische Schicht wird eine Schicht bezeichnet, bei der das Material der Schicht aus einem Metall oder Legierungen von Metallen besteht. Der erste und/oder zweite Beschichtungsschritt können jeweils Teilschritte umfassen.

Erfindungsgemäß können mit der Aufbringung der weiteren Schichten elektrisch nicht-leitfähige Schichtsysteme, die beispielsweise Farbeffekte aufweisen, erzeugt werden. Ferner können die weiteren Schichten mechanischen Schutz gewährleisten oder dazu dienen bestimmte Eigenschaften der Oberfläche einzustellen, ohne das das Schichtsystem die Hochfrequenz-Transparenz zu verliert. Die Erfindung geht von der Erkenntnis aus, dass eine elektrisch nichtleitfähige metallische Schicht eine Struktur aus Metallinseln aufweist. Erfindungsgemäß wird eine solche Schicht als Grundlage eines Schichtsystems einer weiteren Beschichtung ausgesetzt, wobei die steilen Ränder der Inseln die Bereiche zwischen den Inseln zumindest teilweise vor dem Beschichtungsfluss abschatten. In der Folge weist die nachträglich aufgebrachte Schicht ebenfalls eine Inselstruktur auf und ist ebenfalls elektrisch nicht-leitfähig und zumindest in einem Bereich von 400 MHz bis 5 GHz Radiofrequenz (RF) -transparent.

Es versteht sich, dass erfindungsgemäß auch mehrere weitere Schichten auf die metallische Schicht aufgebracht werden können, wobei das Schichtsystem aus der metallischen Schicht und den weiteren Schichten einen Flächenwiderstand > 10 MOhm aufweist. Dabei würden diese weiteren Schichten, jeweils bei gleicher Schichtdicke mit einem entsprechenden Beschichtungsschritt auf das Substrat aufgebracht, einen Flächenwiderstand < 1 MOhm aufweisen.

Vorzugsweise ist die metallische Schicht eine NCVM-Schicht, wird also mit einem Vakuumverfahren aufgebracht. Die metallische Schicht kann durch ein PVD-Verfahren (beispielsweise Bedampfen, Sputtern oder eine Kombination beider) oder durch ein PECVD-Verfahren aufgebracht werden. Vorzugsweise wird auch die weitere Schicht mit einem Vakuumverfahren, insbesondere einem reaktiven PVD- oder PECVD- Verfahren aufgebracht. Bei dem Einsatz von Vakuumverfahren ist vorteilhaft, dass Ausbeuteverluste vermieden werden können, die bei der im Stand der Technik verwendeten Farblackierung auftreten würden.

Mit dem Verfahren können vorteilhaft auf einfache Weise Schichtsysteme mit unterschiedlicher Dicke hergestellt werden. Die gesamte Dicke des Schichtsystems aus metallischer Schicht und weiterer Schicht, beispielsweise bei einer $Ti_xN_y$-Schichtn auf einer Zinnschicht, liegt bevorzugt zwischen 100 nm und 400 nm. Die Dicke der metallischen Schicht, kann hierbei in einem Bereich zwischen 30 nm bis 100 nm, insbesondere von 50 nm liegen. Die weitere Schicht hat bevorzugt eine Dicke von > 20 nm und < 300 nm.

Mit dem erfindungsgemäßen Verfahren kann ein Schichtsystem hergestellt werden, welches vorteilhaft einen vom Substrat unterschiedlichen Farbeindruck aufweist. Für die Charakterisierung des Farbeindrucks kann dabei das L\*a\*b\*-Farbsystem herangezogen werden. Das von der CIE-Kommision entwickelte Standardsystem L\*a\*b\*-Farbsystem zur psychophysikalischen Farbstimulusspezifizierung (Commision Internationale de Leclairage, Publication CIE No. 15.2, Colorimetry, 2nd., Central Bureau of the CIE, Vienna 1986) ist beispielsweise in der ASTM Designation 308-01 (Standard Practice for Computing the Colors of Objects by Using the CIE System, November 2001) beschrieben und basiert auf Eigenschaften der menschlichen Wahrnehmung.

Erfindungsgemäß besteht zwischen dem Farbeindruck des Substrats mit aufgebrachtem Schichtsystem und dem Farbeindruck des Substrats ohne Schichtsystem vorzugsweise ein Farbabstand $\Delta E^* = [(L^*_s - L^*)^2 + (a^*_s - a^*)^2 + (b^*_s - b^*)^2]^{1/2} > 2{,}0$, wobei der Farbeindruck des Schichtsystems $F_{Schicht} = (L^*_s, a^*_s, b^*_s)$ und der Farbeindruck des Substrats $F = (L^*, a^*, b^*)$ ist. $L^*$ ist ein Maß für die Helligkeit, $a^*$ für den Rot-Grün- und $b^*$ für den Gelb-Blau-Wert des Farbeindrucks. Der Farbeindruck kann hierbei in Abhängigkeit von der Schichtdicke der weiteren Schicht variiert werden.

Das erfindungsgemäße Schichtsystem nach Anspruch 9 ist auf einem dielektrischen Substrat aufgebracht und weist eine mit einem Beschichtungsschritt aufgebrachte metallische Schicht auf dem Substrat und eine darauf folgende mit einem weiteren Beschichtungsschritt aufgebrachte weitere Schicht mit vorgegebener Schichtdicke auf, wobei die metallische Schicht einen Flächenwiderstand > 10 MOhm sowie einen mittleren Reflektionsgrad > 50% aufweist. Das Schichtsystem zeichnet sich dadurch aus, dass die weitere Schicht, wenn sie bei gleicher Schichtdicke mit dem weiteren Beschichtungsschritt auf das Substrat aufgebracht worden wäre, einen Flächenwiderstand < 1 MOhm aufweisen würde, und dass das Schichtsystem aus der metallischen Schicht und der weiteren Schicht einen Flächenwiderstand > 10 MOhm aufweist.

Das Schichtsystem kann durch die Kombination von nicht-leitfähiger metallischer Schicht und der weiteren nicht-leitfähigen Schicht neue, bisher nicht erzielbare, insbesondere farbige Designeffekte aufweisen. Ferner kann eine verbesserte Lichtbeständigkeit erreicht werden, da keine organischen Farbstoffe vorliegen, die von einem UV-Abbau betroffen sein können.

Vorzugsweise ist die metallische Schicht eine NCVM-Schicht. Vorzugsweise ist auch die weitere Schicht mit einem Vakuumverfahren aufgebracht.

Die metallische Schicht kann aus zumindest einem Element der Gruppe Zinn, Indium, Blei, Wismut, Gallium, Aluminium, Cer, Chrom oder Iridium oder aus einer Legierung aus zumindest zwei Elementen der Gruppe Zinn, Indium, Blei, Wismut, Gallium, Aluminium, Cer, Chrom oder Iridium hergestellt sein, so dass vorteilhaft Schichten mit an unterschiedliche Anwendungsgebiete angepassten unterschiedlichen Eigenschaften erzielt werden können.

Der spezifische Widerstand des Bulk-Materials der weiteren Schicht ist < 1 M Ohmcm, obwohl das Schichtsystem einen Flächenwiderstand > 10MOhm aufweist.

Materialien für die weitere Schicht sind Nitride, Oxinitride, Karbide, Carbonitride oder Boride von geeigneten Metallen vorgesehen, da mit diesen relativ einfach farbige Schichten herstellbar sind.

Erfindungsgemäß wird die weitere Schicht durch reaktives Sputtern von zumindest einem Element der Gruppe Titan, Zirkon, Cer, Aluminium, Iridium, Chrom, Silizium, Niob oder Tantal mit einem Reaktivgas, welches zumindest ein Element der Gruppe Stickstoff, Kohlenstoff, Sauerstoff, Bor umfasst, aufgebracht.

Wenn der mittlere Reflektionsgrad des Schichtsystems, vorzugsweise im Frequenzbereich zwischen 400 MHz und 5 GHz um < 25% von einem entsprechenden mittleren Reflektionsgrad des Substrats ohne Schichtsystem abweicht, liegt damit ein relativ gering reflektierendes Schichtsystem vor.

Vorteilhaft besteht zwischen dem Farbeindruck des Substrats mit aufgebrachtem Schichtsystem und dem Farbeindruck des Substrats ohne Schichtsystem ein Farbabstand $\Delta E^* = [(L^*_s - L^*)^2 + (a^*_s - a^*)^2 + (b^*_s - b^*)^2]^{1/2} > 2,0$. Hierbei ist der Farbeindruck des Schichtsystems $F_{Schicht} = (L^*_s, a^*_s, b^*_s)$ und der Farbeindruck des Substrats $F = (L^*, a^*, b^*)$.

Angewandt werden kann die Erfindung auf die Herstellung eines Schichtsystems für farbige Reflektorschichten: Auf einen Grundreflektor, aufweisend ein Substrat und eine nicht geschlossene metallische Schicht wird eine Schicht aus reaktiv gesputtertem $Ti_xN_y$ (mit 1<x<1,5 und 0,5<y<2) aufgebracht. Abhängig von der konkreten Stöchiometrie der $Ti_xN_y$-Schicht stellen sich optische Eigenschaften (Brechzahl und Absorption) ein, die zusammen mit der Schichtdicke der $Ti_xN_y$-Schicht und den optischen Eigenschaften der darunterliegenden metallischen Schicht, die Reflektionsfarbe des Schichtsystems bestimmen. Das Schichtsystem kann ein metallisches Aussehen aufweisen, da ausreichend Licht reflektiert wird, obwohl die metallische Schicht sehr dünn ist.

Weitere Vorteile des Schichtsystems entsprechen den bereits dargestellten Vorteilen des erfindungsgemäßen Verfahrens.

Das erfindungsgemäße Gehäuse nach Anspruch 16 weist einen Gehäusekörper auf, der als dielektrisches Substrat dient, welches ein dielektrisches Material, bevorzugt Polycarbonat, umfasst, und ein auf dem Substrat aufgetragenes erfindungsgemäßes Schichtsystem aufweist.

Auf Grund des großen Flächenwiderstandes ist das Gehäuse durchlässig für Hochfrequenzstrahlung zwischen 400 MHz und 5 GHz, hat aber trotzdem ein metallisches, beziehungsweise farbiges Aussehen. Das Gehäuse ist außerdem leicht, falls das Substratmaterial aus Kunststoff, beispielsweise Polycarbonat ist.

Weitere Aspekte, Vorteile und Merkmale des erfindungsgemäßen Verfahrens und des Schichtsystems ergeben sich aus den nachfolgenden Ausführungsformen und den Figuren der Zeichnung.

Es zeigen:

Figur 1 eine schematische Darstellung eines beispielhaften Schichtsystems

Figur 2 eine grafische Darstellung, der mit der Schichtdicke der $Ti_xN_y$-Schicht einstellbaren Farben, in einer Projektion des L*a*b*-Farbraumes auf die a*-b*-Ebene

Figur 3 ein Ablaufschema eines typischen erfindungsgemäßen Verfahrens.

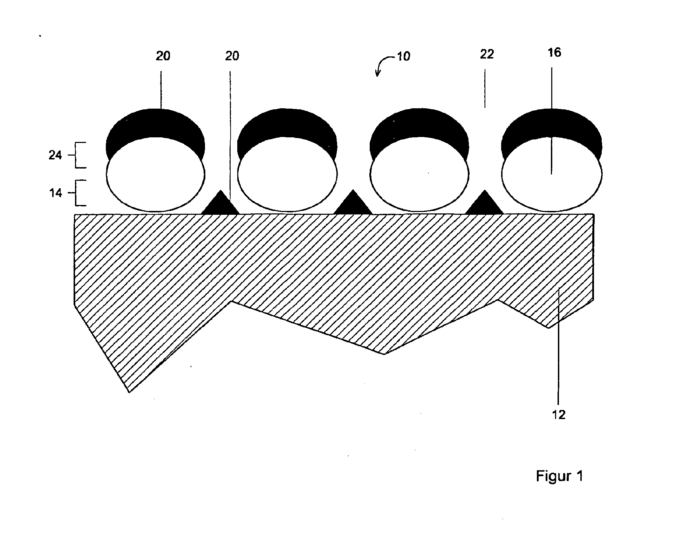

In Figur 1 ist ein Schichtsystem 10 schematisch dargestellt, das auf einem dielektrischen Substrat 12 aufgebracht ist. Das Substrat 12 ist bevorzugt aus einem dielektrischen Material, insbesondere Kunststoff, hergestellt. Besonders bevorzugt besteht das Substrat 12 aus Polycarbonat. Das Substrat 12 kann ein Gehäusekörper, beispielsweise für ein Mobiltelefon, einen Laptop oder ein anderes elektrisches oder elektronisches Gerät sein, oder Teil eines Gehäuses sein. Selbstverständlich kann das Gehäuse auch für ein stationäres Gerät vorgesehen sein.

Die unmittelbar auf dem Substrat 12 aufgebrachte Schicht 14 weist Inseln 16 auf, die ein metallisches Element oder eine metallische Legierung beinhalten. Die Inseln 16 bilden eine nicht geschlossene metallische Schicht auf dem Substrat 12. Zwischen den Inseln 16 bilden sich Täler 22 aus. Die metallische Schicht hat einen Flächenwiderstand von > 10 MOhm.

Auf die vorstehend beschriebene metallische Schicht 14 wird eine weitere Schicht 24 aufgebracht, bevorzugt ebenfalls mittels eines Vakuumprozesses. Die weitere Schicht 24 weist ebenfalls Inseln 20 auf, so dass sich auch bei der weiteren Schicht 24 eine nicht geschlossene Schicht bildet. Somit bestehen keine zusammenhängenden Pfade für elektrische Leitungsvorgänge. Die weitere Schicht 24 ist deshalb ebenfalls elektrisch nicht-leitfähig und transparent für Hochfrequenzstrahlung im Bereich von 400 MHz bis 5 GHz. Der mittlere Reflektionsgrad beträgt bevorzugt mehr als 50%.

Die weitere Schicht 24 hätte einen Flächenwiderstand von <1 MOhm, wenn sie auf ein Substrat 14 aufgebracht worden wäre.

Der spezifische Bulk-Widerstand des Materials der weiteren Schicht 24 beträgt weniger als 1 MOhm. Die weitere Schicht 24 wird aus einem Metall oder einer metallischen Legierung und einem reaktiven Gas hergestellt. Ein typisches verwendetes Metall ist Titan, wobei als reaktives Gas Stickstoff eingesetzt wird und sich eine bevorzugt unterstöchiometrische Titan-NitridSchicht bildet. Es können aber auch andere Metalle verwendet werden, die Oxide, Nitride oder Oxinitride, Karbide oder Boride bilden können.

Bevorzugt wird das Schichtsystem aus der metallischen Schicht 14 und der weiteren Schicht 24 durch einen klaren, kratzfesten Lack geschützt. Dieser ist in der Figur 1 nicht dargestellt.

Das Substrat 12 mit aufgebrachtem Schichtsystem 10 und das Substrat 12 ohne Schichtsystem können einen Farbabstand von $\Delta E^* = [(L^*_s - L^*)^2 + (a^*_s - a^*)^2 + b^*_s - b^*)^2]^{1/2}$ aufweisen, der vorzugsweise größer als 2 ist. Hier ist der Farbeindruck des Schichtsystems $F_{Schicht} = (L^*_s, a^*_s, b^*_s)$ und der Farbeindruck des Substrats $F = (L^*, a^*, b^*)$.

Das Verfahren kann auch Vorbehandlungs- und/oder Reinigungsschritte sowohl des Substrates 12 als auch des Substrates mit der metallischen Schicht 14 umfassen. Ein derartiges Reinigungs- und/oder Vorbehandlungsverfahren kann eine Plasmavorbehandlung sein. Hierbei wird das Substrat 12 durch ein Plasma gereinigt und zur besseren Haftung der nachfolgenden metallischen Schicht 14 aktiviert.

Ausführungsbeispiel eines Verfahrens zur Herstellung eines Schichtsystems:

Im Folgenden wird ein Verfahren zu Herstellung einer metallischen Schicht 14 aus Zinn und einer weiteren Schicht 24 aus Titan-Nitrid (Sn/Ti$_x$N$_y$ mit 1<x<1,5 und 0,5<y<2) beschrieben. Das Substrat wird in eine Vakuumkammer einer Beschichtungsanlage, beispielsweise einer AluMet 900H der Anmelderin, eingebracht. Molybdän-Wendeln werden mit Zinn-Pellets bestückt. Das Substrat wird auf einer Probenhalterung angeordnet, die an einem Beschichtungswagen angebracht ist. Der Beschichtungswagen wird in die Vakuumkammer geschoben. Die Vakuumkammer wird auf $5 \times 10^{-3}$ Pa evakuiert.

Die Probenhalterung rotiert, wobei durch die Heizwendeln ein Strom zum Verdampfen der Zinn -Pellets auf die Substratflächen geführt wird. Hierbei sind die Substratflächen gegenüberliegend der Heizwendeln mit den Zinn-Pellets angeordnet. Die verdampften Zinnteilchen kondensieren auf der Substratoberfläche zu einer Zinnschicht. Die Dicke der Zinnschicht beträgt typischerweise 35 nm. Die aufgebrachten Schichten sind metallisch glänzend mit einer optischen Dichte von etwa 1,5. Dies entspricht etwa 3% Resttransmission. Ferner weist die metallische Schicht 14 eine Reflektion im sichtbaren Wellenlängenbereich von 60% bis 70% sowie einen Flächenwiderstand größer als 10 MOhm auf. Ist der Beschichtungsprozess beendet, wird die Vakuumkammer belüftet und das Substrat mit der metallischen Schicht 14 entnommen.

Im nächsten Verfahrensschritt wird das Substrat 12 mit der metallischen Schicht 14 in eine Beschichtungsanlage, beispielsweise eine Topaz-Reaktiv-Sputteranlage der Anmelderin eingebaut. Der Prozessstartdruck in der Vakuumkammer beträgt $2 \times 10^{-3}$ Pa. Bei einer Sputteratmosphäre von 110 sccm Argon und 200 sccm Stickstoff wird ein Titan-Target mit einer Leistung von 15 kW gesputtert. Hierbei brennt gleichzeitig ein 40 kHz Plasma von 500 W zur Unterstützung der Nitrierungsreaktion.

Tabelle 1: Farben und elektrische Widerstände von gesputterten Ti$_x$N$_y$-Schichten

| | 0,44 nm/s | | | | Widerstand |
|---|---|---|---|---|---|
| Sputterzeit [s] | Dicke [nm] | L* | a* | b* | R, MOhm |
| 0 | 0 | 86,37 | -1,36 | 5,5 | >20 |
| 50 | 22 | 79,3 | -0,82 | 26,61 | >20 |
| 75 | 33 | 67,22 | 6,11 | 53,2 | >20 |
| 100 | 44 | 59,33 | 11,78 | 64,77 | >20 |
| 120 | 52 | 37,89 | 29,62 | 34,3 | >20 |
| 125 | 55 | 33,03 | 27,7 | -3,53 | >20 |

(fortgesetzt)

| Sputterzeit [s] | Dicke [nm] | L* | a* | b* | R, MOhm |
|---|---|---|---|---|---|
| 150 | 66 | 28,4 | 8,05 | -31,21 | >20 |
| 180 | 79,2 | 31,55 | -12,45 | -33,89 | 10...>20 |
| 200 | 88 | 48,66 | -19,45 | -18,42 | >20 |
| 225 | 99 | 57,8 | -18,38 | 1,51 | >17 |
| 250 | 110 | 60,54 | -15,2 | 14,08 | >20 |
| 180 | 79,2 | 57,11 | -1,3 | 14,45 | 0,03 |

Tabelle 1 zeigt die Farbkoordinaten L*, a* und b* von $Ti_xN_y$-Schichten auf einer nicht-leitfähigen Zinnschicht auf einem Glassubstrat in Abhängigkeit von der Sputterzeit in Sekunden und einer resultierenden Dicke der Schicht in nm. Die Farbkoordinate L* bezeichnet die Helligkeit, a* die Rot-Grün-Verschiebung und b* die Gelb-Blau-Verschiebung.

In der rechten Spalte ist der jeweils gemessene Flächenwiderstand R in MOhm angegeben. Die $Ti_xN_y$-Schichten mit einer Dicke zwischen 20 und 110 nm auf der nicht-leitfähigen metallischen Schicht, weisen Widerstände > 10 MOhm auf.

Die letzte Zeile der Tabelle 1 zeigt zum Vergleich die Werte einer $Ti_xN_y$-Schicht von ca. von 80 nm Dicke, die mit den gleichen Prozessparametern und einer Prozesszeit von 180 s auf ein Glassubstrat aufgebracht wurde, wobei ein Flächenwiderstand von 0,03 MOhm gemessen wurde.

Bei den Messungen wurde der Farbeindruck L*a*b* mit einem der CIE Standard Illuminaten, vorzugsweise D65 und einem 2° oder 10° Beobachter ermittelt. Für die Messungen des spektralen Reflektionsgrades kann beispielsweise ein Farbmessgerät der Firma X-Rite Inc. (4300 44th Street SE, Grand Rapids, MI, 49512 USA) Modell SP60 eingesetzt werden.

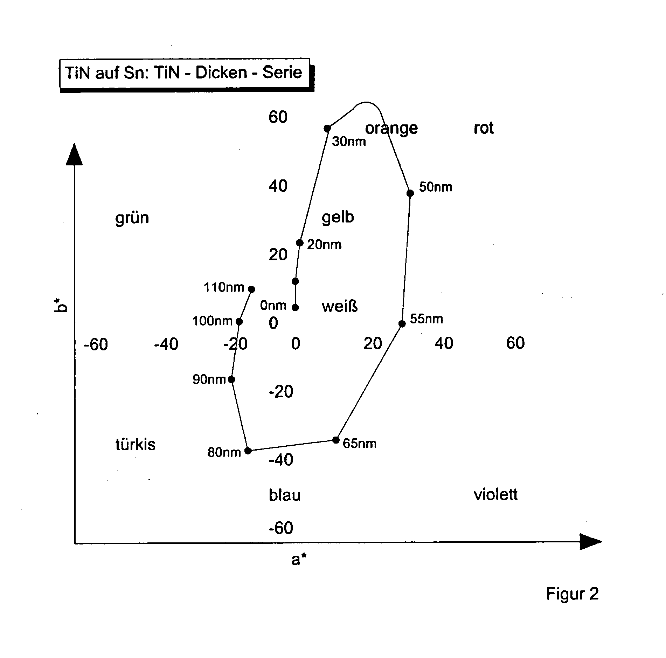

Figur 2 zeigt beispielhaft die von der Dicke der $Ti_xN_y$-Schicht abhängigen Farben in einer Projektion des L*a*b*-Farbraumes auf die a* b*-Ebene als Dickenserie auf einer Zinn-Schicht. Auf der x-Achse ist a* aufgetragen und auf der y-Achse b*. Die Schichtdicke ist jeweils an den Messpunkten angegeben. Es ist zu erkennen, dass unterschiedlichen Schichtdicken von 20 nm bis 110 nm unterschiedliche Farben zugeordnet sind.

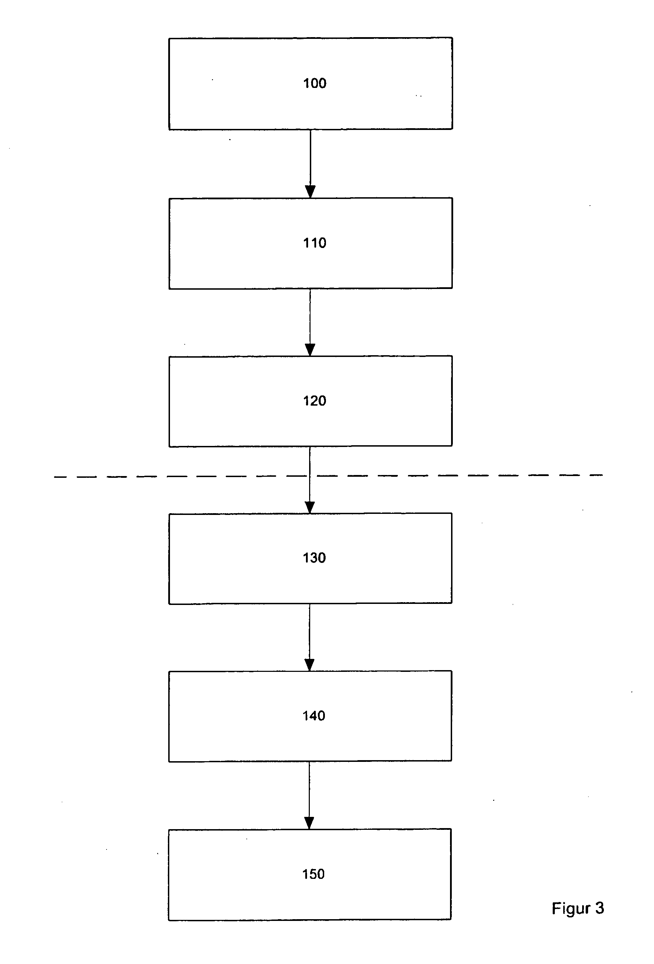

Figur 3 zeigt ein Ablaufschema eines erfindungsgemäßen Verfahrens zur Herstellung eines elektrisch nicht-leitfähigen Schichtsystems.

In Verfahrensschritt 100 wird das Substrat 12 in die Vakuumkammer eingebracht und die Vakuumkammer abgepumpt, typischerweise auf einen Druck von 5 x 10⁻³ Pa.

Im Verfahrensschritt 110 wird das Substrat beschichtet und eine nicht geschlossene metallische Schicht 14 auf dem Substrat abgeschieden.

Im Verfahrensschritt 120 wird die Vakuumkammer belüftet und das Substrat 12 mit der metallischen Schicht 14 aus dieser entfernt. Im Verfahrensschritt 130 wird das Substrat 12 in eine zweite Vakuumkammer eingebaut und diese evakuiert, typischerweise auf einen Druck von 2 x10⁻³ Pa.

Im Verfahrensschritt 140 wird ein Beschichtungsprozess zum Aufbringen einer weiteren Schicht 24 durchgeführt.

Typische erzielte Dicken der weiteren Schicht 24 in Versuchen der Anmelderin liegen bei 20 nm bis 300 nm für $Ti_xN_y$-Schichten. Ist die gewünschte Dicke der weiteren Schicht 24 erreicht, wird das Substrat 12 mit der metallischen Schicht 14 und der weiteren Schicht 24 in Verfahrensschritt 150 aus der Anlage entfernt.

Auch wenn das Verfahren für zwei unterschiedliche Vakuumanlagen dargestellt wurde, kann das Verfahren auch ohne Unterbrechung des Vakuums in dafür geeigneten Vakuumanlagen ausgeführt werden, wobei ein zwischenzeitliches Aus- und Einbauen des Substrats entfallen kann.

Das Verfahren kann weitere hier nicht explizit aufgeführte Vorbehandlungs-, Reinigungsschritte und/oder Verfahrensschritte umfassen.

**Bezugszeichenliste**

10 Schichtsystem
12 Substrat

14 aufgebrachte metallische Schicht
16 metallische Inseln
20 Inseln
22 Tal
24 weitere Schicht

100 Einbau eines Substrates, Evakuieren der Vakuumanlage
110 Beschichten mit einer metallischen Schicht
120 Belüften und Ausbauen des Substrates mit einer metallischen Schicht
130 Einbau in die Beschichtungsanlage für die weitere Schicht
140 Durchführen des Schrittes des Beschichtens mit der weiteren Schicht
150 Belüften und Ausbau des Substrates mit dem Schichtsystem

**Patentansprüche**

1. Verfahren zur Herstellung eines Schichtsystems auf einem dielektrischen Substrat (12), bei dem mit einem Beschichtungsschritt (110) eine metallische Schicht (14) auf das Substrat (12) aufgebracht und darauf folgend mit einem weiteren Beschichtungsschritt (140) eine weitere Schicht (24) mit vorgegebener Schichtdicke aufgebracht wird, wobei die metallische Schicht (14) einen Flächenwiderstand > 10 MOhm, sowie einen mittleren Reflektionsgrad > 50% aufweist, **dadurch gekennzeichnet,**

   - **dass** die weitere Schicht (24) durch reaktives Sputtern mit zumindest einem Element der Gruppe Titan, Zirkon. Silizium, Niob, Tantal, Cer, Aluminium, Iridium, Chrom mit einem Reaktivgas, welches zumindest ein Element der Gruppe Stickstoff, Kohlenstoff, Sauerstoff, Bor, enthält, aufgebracht wird, wobei die weitere Schicht (24), wenn sie bei gleicher Schichtdicke auf das Substrat (12) aufgebracht würde, einen Flächenwiderstand < 1 MOhm aufweisen würde, und
   - **dass** das Schichtsystem (10) aus der metallischen Schicht (14) und der weiteren Schicht (24) einen Flächenwiderstand > 10 MOhm aufweist.

2. Verfahren nach Anspruch 1, **dadurch gekennzeichnet, dass** die metallische Schicht (14) mit einer Schichtdicke > 30 nm und < 100 nm und/oder die weitere Schicht (24) mit einer Schichtdicke > 20 nm und < 300 nm aufgebracht wird.

3. Verfahren nach einem der vorhergehenden Ansprüche, **dadurch gekennzeichnet, dass** die metallische Schicht (14) aus zumindest einem Element der Gruppe Zinn, Indium, Blei, Wismut, Aluminium, Cer, Chrom, Gallium oder Iridium hergestellt wird.

4. Verfahren nach einem der vorhergehenden Ansprüche, **dadurch gekennzeichnet, dass** die metallische Schicht (14) aus einer Legierung aus zumindest zwei Elementen der Gruppe Zinn, Indium, Blei, Wismut, Aluminium, Cer, Chrom, Gallium oder Iridium hergestellt wird.

5. Verfahren nach einem der vorhergehenden Ansprüche, **dadurch gekennzeichnet, dass** die metallische Schicht durch ein Vakuumverfahren, insbesondere ein PVD- oder PECVD-Verfahren und/oder die weitere Schicht (24) durch ein Vakuumverfahren, insbesondere ein reaktives PVD- oder PECVD-Verfahren aufgebracht wird.

6. Verfahren nach einem der vorhergehenden Ansprüche, **dadurch gekennzeichnet, dass** der mittlere Reflektionsgrad des Schichtsystems (10), vorzugsweise im Frequenzbereich zwischen 400 MHz und 5 GHz um < 25% von einem entsprechenden mittleren Reflektionsgrad des Substrats (12) ohne Schichtsystem (10) abweicht.

7. Verfahren nach einem der vorhergehenden Ansprüche, **dadurch gekennzeichnet, dass** zwischen dem Farbeindruck des Substrats (12) mit aufgebrachtem Schichtsystem (10) und dem Farbeindruck des Substrats (12) ohne Schichtsystem ein Farbabstand $\Delta E^* = [(L^*_s - L^*)^2 + (a^*_s - a^*)^2 + (b^*_s - b^*)^2]^{1/2} > 2{,}0$ besteht, wobei der Farbeindruck des Schichtsystems $F_{Schicht} = (L^*_s, a^*_s, b^*_s)$ und der Farbeindruck des Substrats (12)F - (L*, a*, b*) ist.

8. Schichtsystem auf einem dielektrischen Substrat (12), bei dem mit einem Beschichtungsschritt (110) eine metallische Schicht (14) auf das Substrat (12) aufgebracht und darauf folgend mit einem weiteren Beschichtungsschritt (140) eine weitere Schicht (24) mit vorgegebener Schichtdicke aufgebracht ist, wobei die metallische Schicht (14) einen Flächenwiderstand > 10 MOhm sowie einen mittleren Reflektionsgrad > 50% aufweist, **dadurch gekennzeichnet,**

- **dass** die weitere Schicht (24) aus einem Nitrid, Oxinitrid, Karbid, Carbonitrid oder Borid eines Metalls besteht, und
- **dass** das Schichtsystem (10) aus metallischer Schicht (14) und der weiteren Schicht (24) einen Flächenwiderstand > 10 MOhm aufweist, wobei das Schichtsystem mit einem Verfahren nach Anspruch 1 erhältlich ist.

9. Schichtsystem nach Anspruch 8, **dadurch gekennzeichnet, dass** die metallische Schicht (14) eine Schichtdicke > 30 nm und < 100 nm und/oder die weitere Schicht (24) eine Schichtdicke > 20 nm und < 300 nm aufweist.

10. Schichtsystem nach Anspruch 8 oder 9, **dadurch gekennzeichnet, dass** die metallische Schicht (14) aus zumindest einem Element der Gruppe Zinn, Indium, Blei, Wismut, Gallium, Aluminium, Cer, Chrom oder Iridium besteht.

11. Schichtsystem nach einem der vorhergehenden Ansprüche 8 bis 10, **dadurch gekennzeichnet, dass** die metallische Schicht (14) aus einer Legierung aus zumindest zwei Elementen der Gruppe Zinn, Indium, Blei, Wismut, Gallium, Aluminium, Cer, Chrom oder Iridium besteht.

12. Schichtsystem nach einem der Ansprüche 8 bis 11, **dadurch gekennzeichnet, dass** die metallische Schicht durch ein Vakuumverfahren, insbesondere ein PVD- oder PECVD-Verfahren und/oder die weitere Schicht (24) durch ein Vakuumverfahren, insbesondere ein reaktives PVD- oder PECVO-Verfahren aufgebracht ist.

13. Schichtsystem nach Anspruch 12, **dadurch gekennzeichnet, dass** die weitere Schicht (24) durch reaktives Sputtern von zumindest einem Element der Gruppe Titan, Zirkon, Cer, Aluminium, Iridium, Chrom mit einem Reaktivgas, welches zumindest ein Element der Gruppe Stickstoff, Kohlenstoff, Sauerstoff, Bor, Silizium, Niob. Tantal umfasst, aufgebracht ist.

14. Schichtsystem nach einem der vorhergehenden Ansprüche 8 bis 13, **dadurch gekennzeichnet, dass** der mittlere Reflektionsgrad des Schichtsystems (10), vorzugsweise Im Frequenzbereicht zwischen 400 MHz und 5 GHz um < 25% von einem entsprechenden mittleren Reflektionsgrad des Substrats (12) ohne Schichtsystem (10) abweicht.

15. Schichtsystem nach einem der vorhergehenden Ansprüche 8 bis 14, **dadurch gekennzeichnet, dass** zwischen dem Farbeindruck des Substrats (12) mit aufgebrachtem Schichtsystem (10) und dem Farbeindruck des Substrats (12) ohne Schichtsystem ein Farbabstand $\Delta E^* = [(L^*_s - L^*)^2 + (a^*_s - a^*)^2 + (b^*_s - b^*)^2]^{1/2} > 2,0$ besteht, wobei der Farbeindruck des Schichtsystems $F_{Schicht} = (L^*_s, a^*_s, b^*_s)$ und der Farbeindruck des Substrats (12) $F = (L^*, a^*, b^*)$ ist.

16. Gehäuse mit einen Gehäusekörper, der als dielektrisches Substrat dient und einem Schichtsystem nach einem der Ansprüche 8 bis 15.


## Claims

1. Method for producing a layer system on a dielectric substrate (12) in which a metal layer (14) is applied onto the substrate (12) by a coating step (110) and a further layer (24) with a predetermined layer thickness is subsequently applied by a further coating step (140), the metal layer (14) having a sheet resistance > 10 Mohm and an average reflectance > 50%, **characterized in that**

   - the further layer (24) is applied by reactive sputtering with at least one element of the group titanium, zirconium, silicon, niobium, tantalum, cerium, aluminum, iridium, or chromium, with a reactive gas which comprises at least one element of the group nitrogen, carbon, oxygen, or boron, in which the further layer (24), if it is applied onto the substrate (12) with the same layer thickness, would have a sheet resistance < 1 Mohm, and
   - the layer system (10) comprising of the metal layer (14) and the further layer (24) has a sheet resistance > 10 mohm.

2. Method according to Claim 1, **characterized in that** the metal layer (14) is applied with a layer thickness > 30 nm and < 100 nm and/or the further layer (24) is applied with a layer thickness > 20 nm and < 300 nm.

3. Method according to one of the preceding clams, **characterized in that** the metal layer (14) is produced from at least one element of the group tin, indium, lead, bismuth, aluminum, cerium, chromium, gallium or iridium.

4. Method according to one of the preceding claims, **characterized in that** the metal layer (14) is produced from an alloy of at least two elements of the group tin, indium, lead, bismuth, aluminium, cerium, chromium, gallium or iridium.

5. Method according to one of the preceding claims, **characterized in that** the metal layer is applied by a vacuum method, in particular a PVD or PECVD method and/or the further layer (24) is applied by a vacuum method, in particular a reactive PVD or PECVD method.

6. Method according to one of the preceding claims, **characterised in that** the average reflectance of the layer system (10), preferably in the frequency range of between 400 MHz and 5 GHz, differs by < 25% from a corresponding average reflectance of the substrate (12) without the layer system (10).

7. Method according to one of the preceding claims, **characterized in that** there is a color distance $\Delta E^* = [(L^*_1-L^*)^2+(a^*_1-a^*)^2+(b^*_1-b^*)^2]^{1/2} > 2.0$ between the color impression of the substrate (12) with the layer system (10) applied and the color impression of the substrate (12) without the layer system, the color impression of the layer system being $C_{layer} = (L^*_1, a^*_1, b^*_1)$ and the color impression of the substrate (12) being $C = (L^*, a^*, b^*)$.

8. Layer system on a dielectric substrate (12) in which a metal layer (14) is applied onto the substrate (12) by a coating step (110) and a further layer (24) with a predetermined layer thickness is subsequently applied by a further coating step (140), the metal layer (14) having a sheet resistance > 10 Mohm and an average reflectance > 50%, **characterised in that**

   - the further layer (24) consists of a nitride, oxynitride, carbide, carbonitride or boride of a metal, and
   - the layer system (10) comprising the metal layer (14) and the further layer (24) has a sheet resistance > 10 Mohm,

   with the layer system being obtainable by the method according to Claim 1.

9. Layer system according to Claim 8, **characterized in that** the metal layer (14) has a layer thickness > 30 nm and < 100 nm and/or the further layer (24) has a layer thickness > 20 nm and < 300 nm.

10. Layer system according to Claim 8 or 9, **characterised in that** the metal layer (14) comprises at least one element of the group tin, indium, lead, bismuth, gallium, aluminum, cerium, chromium or iridium.

11. Layer system according to one of the preceding Claims 8 to 10, **characterized in that** the metal layer (14) comprises an alloy of at least two elements of the group tin, indium, lead, bismuth, gallium, aluminum, cerium, chromium or iridium.

12. Layer system according to one of Claims 8 to 11, **characterized in that** the metal layer is applied by a vacuum method, in particular a PVD or PECVD method and/or the further layer (24) is applied by a vacuum method, in particular a reactive PVD or PECVD method.

13. Layer system according to Claim 12, **characterized in that** the further layer (24) is applied by reactive sputtering of at least one element of the group titanium, zirconium, cerium, aluminium, iridium, or chromium, with a reactive gas which comprises at least one element of the group nitrogen, carbon, oxygen, boron, silicon, niobium, or tantalum.

14. Layer system according to one of the preceding Claims 8 to 13, **characterized in that** the average reflectance of the layer system (10), preferably in the frequency range of between 400 MHz and 5 GHz, differs by < 25% from a corresponding average reflectance of the substrate (12) without the layer system (10).

15. Layer system according to one of the preceding Claims 8 to 14, **characterized in that** there is a color distance $\Delta E^* = [(L^*_1-L^*)^2+(a^*_1-a^*)^2+(b^*_1-b^*)^2]^{1/2} > 2.0$ between the color impression of the substrate (12) with the layer system (10) applied and the color impression of the substrate (12) without the layer system, the color impression of the layer system being $C_{layer} = (L^*_1, a^*_1, b^*_1)$ and the color impression of the substrate (12) being $C = (L^*, a^*, b^*)$.

16. Housing comprising a housing body, which is used als a dielectric substrate, and a layer system according to one of Claims 8 to 15.

**Revendications**

1. Procédé de fabrication d'un système de couches constitué d'un substrat diélectrique (12), dans lequel une couche métallique (14) est appliquée sur le substrat (12) au cours d'une étape de revêtement (110) et une autre couche (24) d'épaisseur prédéterminée est appliquée ensuite dans une autre étape de revêtement (140), la couche métallique (14) présentant une résistance de surface > 10 MOhm ainsi qu'un taux moyen de réflexion > 50 %,
   **caractérisé en ce que**
   l'autre couche (24) est appliquée par pulvérisation réactive d'au moins un élément de l'ensemble constitué du titane, du zirconium, du silicium, du niobium, du tantale, du cérium, de l'aluminium, de l'iridium et du chrome, avec un gaz réactif qui présente au moins un élément de l'ensemble constitué de l'azote, du carboné, de l'oxygène et du bore, l'autre couche (24) devant présenter une résistance de surface < 1 MOhm lorsqu'elle a été appliquée à épaisseur constante sur le substrat (12), et
   **en ce que** le système de couches (10) constitué de la couche métallique (14) et de l'autre couche (24) présente une résistante de surface > 10 MOhm.

2. Procédé selon la revendication 1, **caractérisé en ce que** la couche métallique (14) est appliquée à une épaisseur > 30 nm et < 100 nm et/ou **en ce que** l'autre couche (24) est appliquée à une épaisseur > 20 nm et < 300 nm.

3. Procédé selon l'une des revendications précédentes, **caractérisé en ce que** la couche métallique (14) est réalisée en au moins un élément de l'ensemble constitué de l'étain, de l'indium, du plomb, du bismuth, de l'aluminium, du cérium, du chrome, du gallium et de l'iridium.

4. Procédé selon l'une des revendications précédentes, **caractérisé en ce que** la couche métallique (14) est réalisée en un alliage constitué d'au moins deux éléments de l'ensemble formé de l'étain, de l'indium, du plomb, du bismuth, de l'aluminium, du cérium, du chrome, du gallium et de l'iridium.

5. Procédé selon l'une des revendications précédentes, **caractérisé en ce que** la couche métallique est appliquée par un procédé sous vide, en particulier un procédé de PVD ou de PECVD, et/ou **en ce que** l'autre couche (24) est appliquée par un procédé sous vide et en particulier un procédé PVD ou PECVD réactif.

6. Procédé selon l'une des revendications précédentes, **caractérisé en ce que** le taux moyen de réflexion du système de couches (10), de préférence dans la plage de fréquence située entre 400 MHz et 5 GHz, s'écarte de < 25 % du taux de réflexion moyen correspondant du substrat (12) sans système de couches (10).

7. Procédé selon l'une des revendications précédentes, **caractérisé en ce que** l'écart de couleur $\Delta E^* = [(L^*_s - L^*)^2 + (a^*_s - a^*)^2 + (b^*_s - b^*)^2]^{1/2}$ entre l'aspect coloré du substrat (12) sur lequel le système de couches (10) a été appliqué et l'aspect coloré du substrat (12) sur un système de couches est > 2,0, l'aspect coloré du système de couches $F_{Schicht}$ étant $(L^*_s, a^*_s, b^*_s)$ et l'aspect coloré du substrat (12) F étant $(L^*, a^*, b^*)$.

8. Système de couches appliqué sur un substrat diélectrique (12), dans lequel une couche métallique (14) est appliquée sur le substrat (12) au cours d'une étape de revêtement (110) et une autre couche (24) d'épaisseur prédéterminée est appliquée ensuite dans une autre étape de revêtement (140), la couche métallique (14) présentant une résistante de surface > 10 MOhm ainsi qu'un taux moyen de déflexion > 50 %, **caractérisé en ce que**
   l'autre couche (24) est constituée d'un nitrure, oxinitrure, carbure, carbonitrure ou borure d'un métal et
   **en ce que** le système de couches (10) constitué de la couche métallique (14) et de l'autre couche (24) présente une résistante de surface > 10 MOhm,
   le système de couches étant obtenu à l'aide d'un procédé selon la revendication 1.

9. Système de couches selon la revendication 8, **caractérisé en ce que** la couche métallique (14) est appliquée à une épaisseur > 30 nm et < 100 nm et/ou **en ce que** l'autre couche (24) est appliquée à une épaisseur > 20 nm et < 300 nm.

10. Système de couches selon les revendications 8 ou 9, **caractérisé en ce que caractérisé en ce que** la couche métallique (14) est réalisée en au moins un élément de l'ensemble constitué de l'étain, de l'indium, du plomb, du bismuth, du gallium, de l'aluminium, du cérium, du chrome et de l'iridium.

11. Système de couches selon l'une des revendications 8 à 10, **caractérisé en ce que** la couche métallique (14) est réalisée en un alliage constitué d'au moins deux éléments de l'ensemble formé de l'étain, de l'indium, du plomb, du bismuth, du gallium, de l'aluminium, du cérium, du chrome et de l'iridium.

12. Système de couches selon l'une des revendications 8 à 11, **caractérisé en ce que** la couche métallique est appliquée par un procédé sous vide, en particulier un procédé de PVD ou de PECVD, et/ou **en ce que** l'autre couche (24) est appliquée par un procédé sous vide, en particulier un procédé PVD ou PECVD réactif.

13. Système de couches selon la revendication 12, **caractérisé en ce que** l'autre couche (24) est appliquée par pulvérisation réactive d'au moins un élément de l'ensemble constitué du titane, du zirconium, du cérium, de l'aluminium, de l'iridium et du chrome à l'aide d'un gaz réactif qui comporte au moins un élément de l'ensemble constitué de l'azote, du carbone, de l'oxygène, du bore, du silicium, du niobium et du tantale.

14. Système de couches selon l'une des revendications 8 à 13 qui précèdent, **caractérisé en ce que caractérisé en ce que** le taux moyen de réflexion du système de couches (10), de préférence dans la plage de fréquence située entre 400 MHz et 5 GHz, s'écarte de < 25 % du taux de réflexion moyen correspondant du substrat (12) sans système de couches (10).

15. Système de couches selon l'une des revendications 8 à 14 qui précèdent, **caractérisé en ce que** l'écart de couleur $\Delta E^* = [(L^*_s - L^*)^2 + (a^*_s - a^*)^2 + (b^*_s - b^*)^2]^{1/2}$ entre l'aspect coloré du substrat (12) sur lequel le système de couches (10) a été appliqué et l'aspect coloré du substrat (12) sur un système de couches est > 2,0, l'aspect coloré du système de couches $F_{Schicht}$ étant $(L^*_s, a^*_s, b^*_s)$ et l'aspect coloré du substrat (12) F étant $(L^*, a^*, b^*)$.

16. Boîtier doté d'un corps de boîtier qui sert de substrat diélectrique et d'un système de couches selon l'une des revendications 8 à 15.

Figur 1

Figur 2

Figur 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4431711 A
- JP 05065650 A

- US 20030031891 A1